# EUROPEAN PATENT SPECIFICATION

(11) **EP 3 546 748 B1**
(45) Date of publication and mention of the grant of the patent: **30.06.2021**
(21) Application number: 17873075.0
(22) Date of filing: 28.11.2017
(51) Int. Cl.: F04B 37/04, F04B 37/02, F04B 23/14, F04B 37/08, F04B 37/14

(54) **NON-EVAPORATIVE GETTER-COATED COMPONENT, CHAMBER, MANUFACTURING METHOD, AND MANUFACTURING APPARATUS**
MIT NICHT-VERDAMPFENDEM GETTER BESCHICHTETE KOMPONENTE, KAMMER , HERSTELLUNGSVERFAHREN, UND HERSTELLUNGSVORRICHTUNG
RÉCIPIENT REVÊTUS DE SORBEUR NON ÉVAPORATIF, CHAMBRE, PROCÉDÉ DE FABRICATION, ET APPAREIL DE FABRICATION

(30) Priority: 28.11.2016 JP 2016230510
(43) Date of publication of application: 02.10.2019
(73) Proprietor: Inter-University Research Institute Corporation High Energy Accelerator Research Organization, Tsukuba-shi Ibaraki 305-0801 (JP)
(72) Inventor: MASE Kazuhiko, Tsukuba-Shi Ibaraki 305-0801 (JP); KIKUCHI Takashi, Tsukuba-Shi Ibaraki 305-0801 (JP)
(74) Representative: Scott, Stephen John
(86) International application number: PCT/JP2017/042682
(87) International publication number: WO 2018/097325

(56) References cited:
- JP-A- 2001 503 830
- JP-A- 2008 532 756
- JP-U- H0 536 078
- US-A1- 2003 203 105
- US-A1- 2008 213 539
- US-B1- 6 468 043

## Description

### TECHNICAL FIELD

The present disclosure relates to a non-evaporable getter (hereinafter referred to also as "NEG") coated component and chamber and a manufacturing method and a manufacturing apparatus thereof.

### BACKGROUND

In the field of vacuum science and technology, a non-evaporable getter (NEG) pump has attracted attention as a vacuum pump that consumes less energy and enables pumping in a wide pressure range. A NEG pump is a vacuum pump that cleans a NEG surface by heating in a vacuum and adsorbs gas remaining in a vacuum apparatus to which the NEG pump is connected to pump the vacuum apparatus.

A study has been carried out to make the entire inner surface of a vacuum chamber to be served as a NEG pump by coating the inner surface of a chamber body of the vacuum chamber with NEG material, typical examples of which including titanium (Ti), zirconium (Zr), vanadium (V), hafnium (Hf), niobium (Nb), tantalum (Ta) and alloys thereof (hereinafter referred to also as "NEG material such as Ti") (see Non-patent Literature 1 (NPL 1)). Ti, Zr and Hf are particularly preferable among NEG materials since they can be activated at a relatively low temperature such as about 200 °C. However, with these NEG materials, there has been a significant decrease in the pumping capacity (NEG performance) when a process of pumping, activation and returning to the atmospheric pressure (referred to also as "atmospheric pressure vent") is repeated (Non-patent Literature 2 (NPL 2)). Therefore, in recent years, as a coating that is unlikely to cause such decrease in NEG performance, coating of noble metals such as Pd (palladium (Pd), gold (Au), silver (Ag), platinum (Pt), rhodium (Rh), iridium (Ir), ruthenium (Ru), osmium (Os) and alloys thereof) (hereinafter referred to also as "noble metals such as Pd") on a NEG material such as Ti has attracted attention (Non-patent Literature 3 (NPL 3)). Among noble metals such as Pd, Pd is especially preferable since it has a function of dissociating hydrogen molecules into hydrogen atoms on the surface and diffusing the hydrogen atoms into the bulk. Further, since the noble metals such as Pd have catalysis, even if the surface thereof is contaminated with carbon, nitrogen, oxygen and the like, it is recovered to a clean surface when it is heated under introduction of a trace of oxygen. Thus a decrease in NEG performance is unlikely to be caused thereby. Moreover, since water (H₂O) does not adsorb onto the surface of noble metal such as Pd at a room temperature, it has an advantage of being able to pump H₂O in a short time. Conventionally, sputtering has been used for coating of these NEG materials and noble metals such as Pd (see Patent Literature 1 (PTL 1)).

### CITATION LIST

### Patent Literature

PTL 1: JP4451498 (B2)

### Non-patent Literature

NPL 1: C. Benvenuti et al., Vacuum 50 (1998) 57
NPL 2: C. Benvenuti et al., Vacuum 60 (2001) 57
NPL 3: C. Benvenuti et al., Vacuum 73 (2004) 139

### SUMMARY

### (Technical Problem)

However, the conventional NEG coated components and NEG coated chambers to which sputtering is used for film formation of NEG materials such as Ti and noble metals such as Pd have problems such as high cost, NEG material layer and noble metal layer easily contaminated by oxygen and the like, difficulty in coating a vacuum tube having a small inner diameter (e.g. 10 mm or less), an increase in a temperature at which NEG material such as Ti is activated (e.g. in the case of Ti, it is 200 °C or more), and the like (see NPL 2).

It is therefore an object of the present disclosure to provide NEG coated components and chambers that are less likely to cause a decrease in pumping capacity (NEG performance), can be applied to a chamber having a smaller inner diameter and have a lower NEG activation temperature, and a method and an apparatus for manufacturing such components and chambers at a low cost.

### (Solution to Problem)

Summary of the present disclosure is as follows:
A disclosed NEG coated component includes a non-evaporable getter material layer with a total storage capacity of carbon atoms, nitrogen atoms and oxygen atoms of 9 mol% or less and/or a noble metal layer with a total storage capacity of carbon atoms, nitrogen atoms and oxygen atoms of 12 mol% or less, and demonstrates a performance of pumping residual gas by heating at an activation temperature of 185°C or less under low pressure.

Further, in a disclosed NEG coated chamber, an inner surface of a vacuum chamber is coated with a non-evaporable getter material layer with a total storage capacity of carbon atoms, nitrogen atoms and oxygen atoms of 9 mol% or less and/or a noble metal layer with a total storage capacity of carbon atoms, nitrogen atoms and oxygen atoms of 12 mol% or less, and a performance of pumping residual gas is demonstrated by heating at an activation temperature of 185°C or less under low pressure.

The disclosed NEG coated component includes a non-evaporable getter material layer with a total storage capacity of carbon atoms, nitrogen atoms and oxygen atoms of 1 mol% or less and/or a noble metal layer with a total storage capacity of carbon atoms, nitrogen atoms and oxygen atoms of 1 mol% or less, and demonstrates a performance of pumping residual gas by heating at an activation temperature of 133°C or less under low pressure.

In the disclosed NEG coated chamber, an inner surface of a vacuum chamber is coated with a non-evaporable getter material layer with a total storage capacity of carbon atoms, nitrogen atoms and oxygen atoms of 1 mol% or less and/or a noble metal layer with a total storage capacity of carbon atoms, nitrogen atoms and oxygen atoms of 1 mol% or less, and a performance of pumping residual gas is demonstrated by heating at an activation temperature of 133°C or less under low pressure.

A disclosed manufacturing method of the NEG coated component includes a step of forming a NEG material layer and/or a noble metal layer by coating a substrate with a NEG material and/or a noble metal by a vapor deposition method under low pressure.

Further, the disclosed manufacturing method of the NEG coated chamber includes a step of forming a NEG material layer and/or a noble metal layer by coating an inner surface of a vacuum chamber with a NEG material and/or a noble metal by a vapor deposition method under low pressure.

A disclosed manufacturing apparatus of the NEG coated component includes a substrate, a NEG material filament and/or a noble metal filament and a current feedthrough.

Further, the disclosed manufacturing apparatus of the NEG coated chamber includes a vacuum chamber, a NEG material filament and/or a noble metal filament and a current feedthrough.

A disclosed method improves a performance of pumping residual gas of the disclosed NEG coated component by using catalytic action of the noble metal layer of the disclosed NEG coated component, in which at least carbon, nitrogen and oxygen contaminants on a surface are removed by heating under introduction of oxygen.

A disclosed method improves a performance of pumping residual gas of the disclosed NEG coated chamber by using catalytic action of the noble metal layer of the disclosed NEG coated chamber, in which at least carbon, nitrogen and oxygen contaminants on a surface are removed by heating under introduction of oxygen.

A disclosed apparatus improves a performance of pumping residual gas of the disclosed NEG coated component by using catalytic action of the noble metal layer of the disclosed NEG coated component, in which at least carbon, nitrogen and oxygen contaminants on a surface are removed by heating under introduction of oxygen.

A disclosed apparatus improves a performance of pumping residual gas of the disclosed NEG coated chamber by using catalytic action of the noble metal layer of the disclosed NEG coated chamber, in which at least carbon, nitrogen and oxygen contaminants on a surface are removed by heating under introduction of oxygen.

### (Advantageous Effect)

According to the present disclosure, a NEG coated component and a NEG coated chamber that are unlikely to cause a decrease in pumping capacity, can be applied to a chamber with a smaller diameter and have a lower NEG activation temperature and can be manufactured at a low cost.

### BRIEF DESCRIPTION OF THE DRAWINGS

In the accompanying drawings:
FIG. 1A is a cross-sectional view illustrating a part of a NEG coated component according to the present disclosure coated with a NEG material such as Ti and a noble metal such as Pd;
FIG. 1B is diagram schematically illustrating a manufacturing method and a manufacturing apparatus of a component coated with a NEG material such as Ti and a noble metal such as Pd according to the present disclosure, in which a top view is illustrated above and a perspective view is illustrated below;
FIG. 2A is a schematic cross-sectional view illustrating a chamber coated with a NEG material such as Ti and a noble metal such as Pd and a part of a manufacturing apparatus thereof according to the present disclosure;
FIG. 2B is a diagram schematically illustrating a manufacturing method and a manufacturing apparatus of a chamber coated with a NEG material such as Ti and a noble metal such as Pd according to the present disclosure;
FIG. 3 is a diagram illustrating pumping curves of vacuum chambers according to Examples 1 and 2 and Comparative Example 1, in which the vertical axis represents the pressure (Pa) in a vacuum chamber and the horizontal axis represents the time (hour) from the start of vacuum pumping;
FIG. 4 is a diagram illustrating a change in pressure over time when a vacuum valve connected to a pumping system is closed at the time when the pressure drops to about 4 × 10⁻⁸ Pa in the vacuum chamber of Examples 1 and 2 and Comparative Example 1, in which the vertical axis represents the pressure (Pa) in the vacuum chamber and the horizontal axis represents the time (hour) after the vacuum valve is closed;
FIG. 5 is a diagram illustrating a non-evaporable getter material layer and a noble metal layer when a total storage capacity of carbon atoms, nitrogen atoms and oxygen atoms is 20 mol% or less;
FIG. 6 is a diagram illustrating a non-evaporable getter material layer and a noble metal layer when a total storage capacity of carbon atoms, nitrogen atoms and oxygen atoms is 1 mol% or less;
FIG. 7 is a schematic cross-sectional view illustrating a chamber coated with a NEG material such as Ti and a noble metal such as Pd and a part of a manufacturing apparatus thereof according to the present disclosure;
FIG. 8 is a schematic cross-sectional view illustrating a part of an apparatus that measures a change in pressure over time of formed bellows of Example 3 and Comparative Example 2; and
FIG. 9 is a diagram illustrating a change in pressure over time when an all-metal valve connected to a pumping system is closed at the time when the pressure drops to about 10⁻⁷ Pa to 10⁻⁸ Pa after the formed bellows of Example 3 and Comparative Example 3 are vacuum pumped and baked, in which the vertical axis represents the pressure (Pa) in the vacuum chamber and the horizontal axis represents the time (min.) after the vacuum valve is closed.

### DETAILED DESCRIPTION

A NEG coated component and a NEG coated chamber, and a manufacturing method and a manufacturing apparatus of the NEG coated component and the NEG coated chamber according to the present disclosure will be illustrated in detail below with reference to the drawings.

### (Manufacturing method of NEG coated component and NEG coated chamber)

The manufacturing method of the NEG coated component according to an embodiment of the present disclosure (hereinafter referred to also as "the present embodiment") includes a step of forming a layer of NEG material such as Ti by coating a substrate with a NEG material such as Ti by the vapor deposition method under low pressure. This manufacturing method may include a step of forming a layer of noble metal such as Pd by coating a layer of noble metal such as Pd further on a layer of a NEG material such as Ti coated on the substrate by the vacuum vapor deposition method.

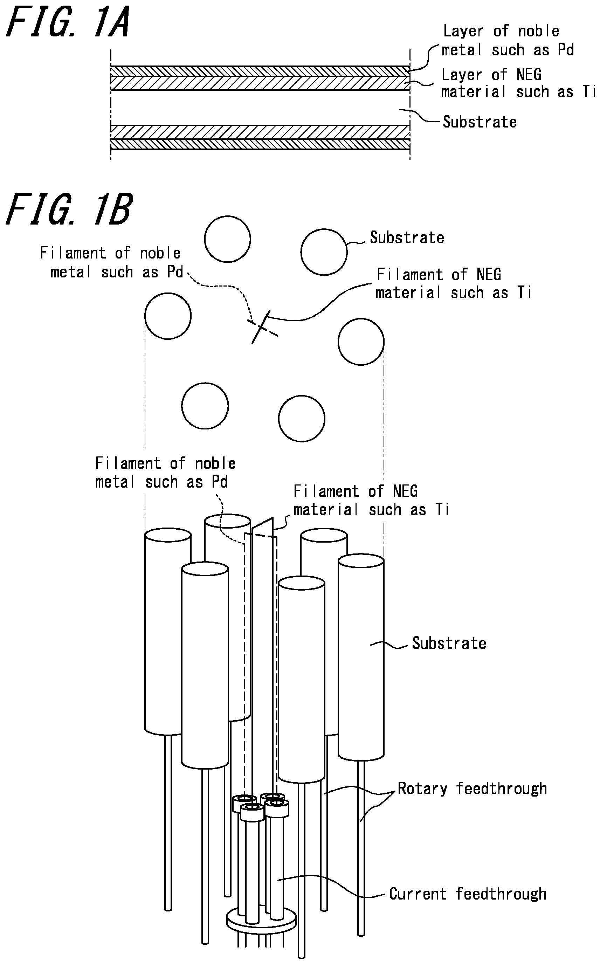

FIG. 1A is a cross-sectional view illustrating a part of a NEG coated component according to the present disclosure coated with a NEG material such as Ti and a noble metal such as Pd, and FIG. 1B is diagram schematically illustrating a manufacturing method and a manufacturing apparatus of a component coated with a NEG material such as Ti and a noble metal such as Pd according to the present disclosure. In FIG. 1B, a top view is illustrated above and a perspective view is illustrated below.

As a vapor deposition method, vacuum vapor deposition (especially the vacuum vapor deposition in which a metal filament is resistance heated) by which impurities such as oxygen can be reduced is preferable.

In a resistance heating type vacuum vapor deposition, a metal may be sublimated by electrically heating a filament of metal (Ti, Pd, etc.) for coating under low pressure of about 10⁻⁵ Pa or less.

In a manufacturing method of a NEG coated component by vacuum vapor deposition, the vacuum vapor deposition of metal (Ti, Pd, etc.) may be performed by, for example, under low pressure of about 10⁻⁵ Pa or less, disposing a substrate around a linear filament along an axial direction thereof, the filament being connected to a current feedthrough, and supplying current from the current feedthrough to the filament (see FIG. 1B). In view of avoiding breakage of a filament and risk reduction, the current value of the filament may be 10 A to 100 A, and may preferably be 20 A to 50 A.

In this case, as illustrated in FIG. 1B, a filament of NEG material such as Ti and a filament of noble metal such as Pd (e.g. made by Nilaco Corporation) may be connected to a current feedthrough having four pins (e.g. a four-pin current feedthrough made by CANON ANELVA Corporation, rated current: 50 A) and current is applied to the NEG material such as Ti and the noble metal such as Pd to form a layer of NEG material such as Ti and a layer of noble metal such as Pd sequentially on the substrate.

Further, in this case, as illustrated in FIG. 1B, a plurality of substrates (e.g. six pieces as illustrated in FIG. 1B) may be disposed around the linear filaments such that the substrates may preferably be point symmetry with respect to the filaments as illustrated above in FIG. 1B, and a layer of NEG material such as Ti and a layer of noble metal such as Pd may be sequentially formed while rotating each substrate at a constant rate around a rotary feedthrough provided relative to each substrate along an extending direction of the filament. This method enables NEG coating to be carried out efficiently and homogeneously.

Further, in this case, more than one kind of filaments of NEG material such as Ti may be prepared to form a NEG material layer composed of NEG alloy of Ti-Zr-V and the like. Moreover, more than one kind of filaments of noble metal such as Pd may be prepared to form a noble metal layer composed of noble metal alloy such as Pd-Ag and the like.

The shape and the size of the substrate are not particularly limited. The material of the substrate is not particularly limited, and examples thereof include stainless steel (e.g. SS304, SS304L, SS316, SS316L, etc.), oxygen-free copper, copper alloy, titanium, titanium alloy, aluminum alloy and the like.

The diameter of the filament is not particularly limited, and may be 0.5 mm to 1.5 mm. The length of the filament is not particularly limited, and may be 10 mm to 4,000 mm. It is to be noted that a support made of insulating material may be provided to hold a filament tip to prevent the filament from being bent when heated. Further, a shield that prevents a NEG material such as Ti from being vapor deposited on a filament of noble metal such as Pd and a shield that prevents a noble metal such as Pd from being vapor deposited on a filament of NEG material such as Ti may be appropriately provided.

Heating temperature may be appropriately determined according to the type of metal. A temperature at which a pressure of vapor of the metal for coating of about 10⁻² Pa to 10⁻⁴ Pa can be obtained is preferable. For example, it may be 1,300 °C to 1,600 °C for Ti and 1,000 °C to 1,200 °C for Pd, for example.

A pressure of a chamber when vacuum vapor deposition is carried out may preferably be about 1/100 or less of the pressure of vapor of the metal at a temperature at which vacuum vapor deposition is carried out. For example, when sublimating at a temperature at which a pressure of vapor of Ti will be about 10⁻⁴ Pa, a pressure of the vacuum chamber may preferably be about 10⁻⁶ Pa or less. This is because when coating is carried out under this condition, impurities derived from residual gas during Ti coating are expected to be reduced to about 1 mol% or less.

It is to be noted that, in the present embodiment, when NEG material is used for a substrate, a layer of noble metal such as Pd may be formed on a NEG material substrate without forming a layer of NEG material such as Ti.

The manufacturing method of a NEG coated chamber according to the present embodiment includes a step of forming a layer of NEG material such as Ti by coating an inner surface of a vacuum chamber with a NEG material such as Ti by a vacuum vapor deposition method under low pressure. This manufacturing method may include a step of forming a layer of noble metal such as Pd by further coating a layer of NEG material such as Ti coated over an inner surface of a vacuum chamber with a noble metal such as Pd by a vacuum vapor deposition method.

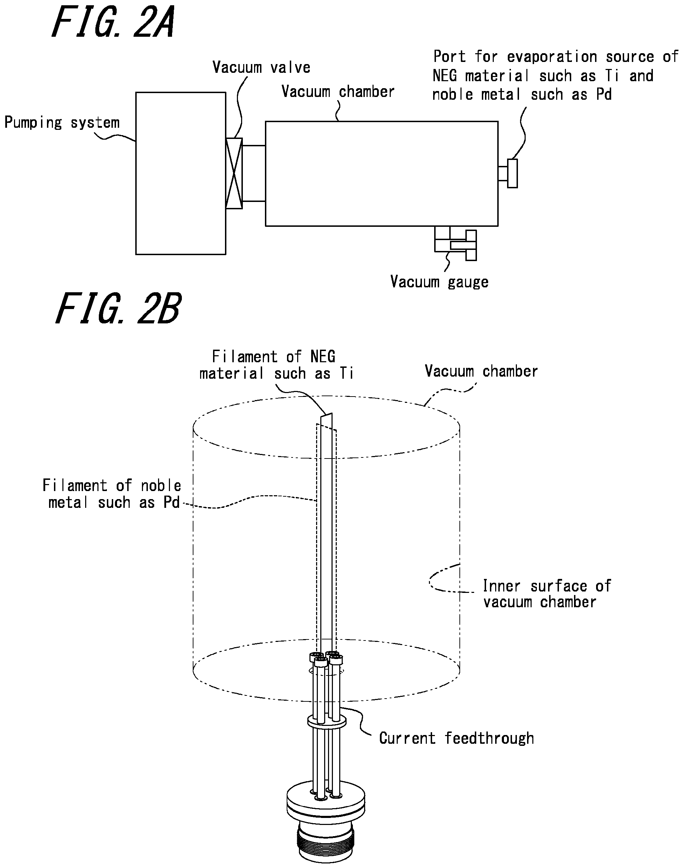

FIG. 2A is a schematic cross-sectional view illustrating a chamber coated with a NEG material such as Ti and a noble metal such as Pd and a part of a manufacturing apparatus thereof according to the present disclosure, and FIG. 2B is a diagram schematically illustrating a manufacturing method and a manufacturing apparatus of a chamber coated with a NEG material such as Ti and a noble metal such as Pd according to the present disclosure.

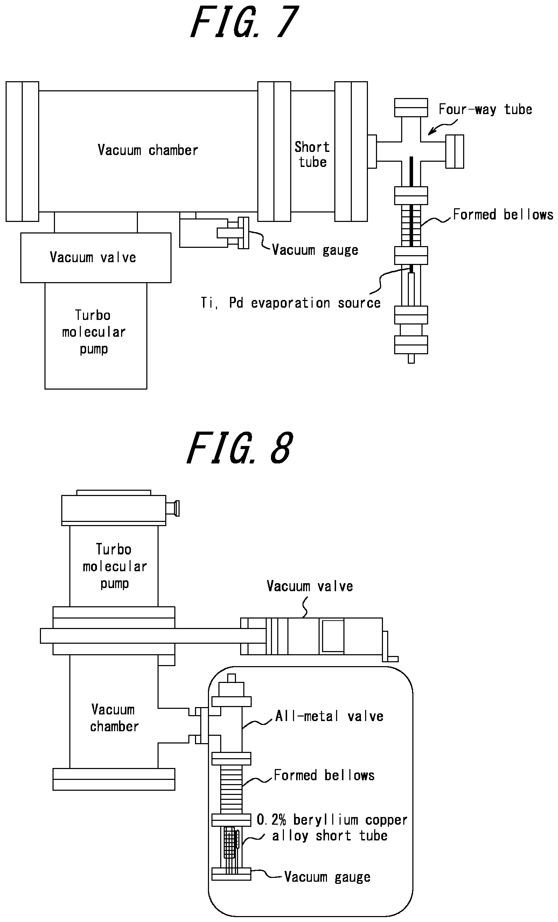

FIG. 7 is a schematic cross-sectional view illustrating a chamber coated with a NEG material such as Ti and a noble metal such as Pd and a part of a manufacturing apparatus thereof according to the present disclosure.

As a vacuum vapor deposition method, resistance heating of a filament of NEG material such as Ti and a filament of noble metal such as Pd is preferable since vapor deposition can be applied to a relatively wide area in a relatively homogeneous manner.

In a manufacturing method of a chamber coated with NEG by vacuum vapor deposition, for example, under low pressure, a linear filament connected to a current feedthrough is disposed in the center inside the chamber, and current is applied from the current feedthrough to the filament to vapor deposit the metal (Ti, Pd, etc.) (see FIG. 2B). The current value of the filament may be 10 A to 100 A, and may preferably be 20 A to 50 A.

Further, in this case, a hollow rotary feedthrough is provided and metal (Ti, Pd, etc.) may be vapor deposited while rotating a filament of NEG material such as Ti and/or a filament of noble metal such as Pd together with a current feedthrough. In this case, although a filament may be rotated in one direction, it may be rotated in that direction and an opposite direction thereof to prevent a wire from being twisted. This method enables homogeneous NEG coating in a wide area.

In this case, more than one kind of filaments of NEG material such as Ti may be prepared to form a NEG material layer of NEG alloy of Ti-Zr-V and the like. Further, more than one kind of filaments of noble metal such as Pd may be prepared to form a noble metal layer of noble metal alloy such as Pd-Ag and the like.

The shape and the size of the vacuum chamber are not limited in particular as far as a filament such as Ti and Pd can be disposed therein. Any material may be used for the vacuum chamber, and examples of the material include stainless steel (e.g. SS304, SS304L, SS316, SS316L, etc.), oxygen-free copper, copper alloy, titanium, titanium alloy, aluminum alloy and the like. It is to be noted that the inner surface of the vacuum chamber may preferably be electrolytically polished or chemically polished.

Other conditions of vacuum vapor deposition may be the same as those of the manufacturing method of NEG coated component according to the present embodiment (see FIG. 2B).

With respect to the NEG coated component and the NEG coated chamber manufactured by the conventional manufacturing method using sputtering, a titanium compound (titanium oxide) is formed inside and on the surface of a layer of NEG material such as Ti due to by-products such as water and oxygen generated by a reaction of rare gas ion such as argon with a substrate, which may make hydrogen dissociation on the surface of a layer of NEG material such as Ti and hydrogen storage inside the NEG material such as Ti less likely to occur. As a result, NEG activation temperature may be increased. Further, conventionally, there are some cases where oxide is generated inside or on the surface of a layer of noble metal such as Pd due to a by-product such as water and oxygen produced by a reaction of rare gas ion such as argon used for sputtering with a substrate, and it is possible that hydrogen dissociability on the surface of a noble metal such as Pd and hydrogen penetrability inside a noble metal such as Pd may be decreased. As a result NEG activation temperature may be increased.

Further, the shape of the NEG coated chamber manufactured by the conventional manufacturing method using sputtering is limited to those having a space necessary for plasma production (e.g. those having an inner diameter of 10 mm or more).

NEG coated components and NEG coated chambers manufactured by using a manufacturing method of the present embodiment include a layer of NEG material such as Ti that includes impurities such as oxygen, carbon, nitrogen and the like only by a predetermined amount or less, and thus hydrogen dissociation ability on the surface of NEG material such as Ti and hydrogen storage ability inside the NEG material such as Ti may easily occur. Thus, according to the present embodiment, NEG coated components and NEG coated chambers that decrease the activation temperature of NEG material such as Ti are less likely to cause a decrease in pumping capacity and can be manufactured at a low cost.

Further, in the present embodiment, unlike the sputtering, plasma is not used, and obtained NEG coated components and NEG coated chambers include a layer of noble metal such as Pd that contains less by-products such as oxygen, carbon, nitrogen and the like, and thus a decrease in hydrogen dissociability on the surface of noble metal such as Pd and hydrogen penetrability inside the noble metal such as Pd can be suppressed. As a result, according to the present embodiment, NEG coated components and NEG coated chambers that are unlikely to cause a decrease in pumping capacity even if pumping, activation and atmospheric pressure vent are repeated can be manufactured at a low cost.

Moreover, the manufacturing method of NEG coated component and NEG coated chamber according to the present embodiment requires no large-scale apparatus such as a plasma genenrator, and thus cost reduction can be realized.

Furthermore, in the manufacturing method of a NEG coated chamber according to the present embodiment, no plasma is used, and thus the method is applicable up to a chamber with inner diameter that is larger than outer diameter of the metal filament by 2 mm.

Each component such as a substrate, a filament of NEG material such as Ti and a filament of noble metal such as Pd, a current feedthrough and a rotary feedthrough and the like in the manufacturing method of the NEG coated component illustrated in FIG. 1B may constitute a manufacturing apparatus of the NEG coated component in the present embodiment.

In the same manner, each component such as a vacuum chamber, a filament of NEG material such as Ti and a filament of noble metal such as Pd, a current feedthrough and a rotary feedthrough and the like in the manufacturing method of the NEG coated chamber illustrated in FIG. 2B may constitute a manufacturing apparatus of the NEG coated chamber in the present embodiment.

The NEG coated component according to the present embodiment includes a layer of NEG material such as Ti with a total storage capacity of carbon atoms, nitrogen atoms and oxygen atoms of 20 mol% or less. The NEG coated component according to the present embodiment may optionally include a layer of noble metal such as Pd with a total storage capacity of carbon atoms, nitrogen atoms and oxygen atoms of 20 mol% or less on a layer of NEG material such as Ti. It is to be noted that the NEG coated component according to the present embodiment may not include a layer of NEG material such as Ti when a NEG material is used as a substrate.

In view of improvement in the effect of the present disclosure, the above described total storage capacity of carbon atoms, nitrogen atoms and oxygen atoms may preferably be 16 mol% or less, more preferably be 13 mol% or less and even more preferably be 10 mol% or less. The lower limit is not particularly limited, but may be 0.0001 mol% or more, 0.01 mol% or more and 0.1 mol% or more.

The thickness of the layer of NEG material such as Ti may be 10 µm to 0.01 µm, preferably be 2 µm to 0.1 µm, and practically be 1 µm.

The thickness of the layer of noble metal such as Pd may be 1,000 nm to 0.3 nm, preferably be 100 nm to 1 nm, and practically be 10 nm.

It is to be noted that the above described thicknesses may be an average thickness.

The layer of NEG material such as Ti may be formed at least a part on the substrate, may be formed in the widest range as possible, and may preferably be formed over the entire surface. The layer of noble metal such as Pd may be formed at least a part of the layer of NEG material such as Ti, may be formed in the widest range as possible, and may preferably be formed over the entire surface.

Other details of the NEG coated components may be as described in the manufacturing method of the NEG coated chamber of the present embodiment.

The NEG coated chamber of the present embodiment may be provided by optionally coating, on the inner surface of the vacuum chamber, a layer of noble metal such as Pd with a total storage capacity of carbon atoms, nitrogen atoms and oxygen atoms of 20 mol% or less further on a layer of NEG material such as Ti with a total storage capacity of carbon atoms, nitrogen atoms and oxygen atoms of 20 mol% or less. In this case, a change in pressure over time in the vacuum chamber after vacuum pumping, a change in pressure over time in the vacuum chamber after the vacuum chamber is heated at 200 °C to activate NEG, and a change in pressure over time in the vacuum chamber after a vacuum valve is closed can be measured.

In view of improvement in the effect of the present disclosure, the above described total storage capacity of carbon atoms, nitrogen atoms and oxygen atoms may preferably be 16 mol% or less, more preferably be 13 mol% or less and even more preferably be 10 mol% or less. The lower limit is not paticularly limited, but it may be 0.0001 mol% or more, 0.01 mol% or more and 0.1 mol% or more.

Details of the NEG coated chamber may be the same as those described in the manufacturing method of the NEG coated chamber according to the present embodiment.

As described above, in the NEG coated component and the NEG coated chamber according to the present embodiment, hydrogen dissociation and hydrogen storage of the layer of NEG material such as Ti are likely to occur, and a decrease in hydrogen dissociability and hydrogen penetrability of the layer of noble metal such as Pd can be suppressed. In this manner, even if pumping, activation and atmospheric pressure vent are repeated, a decrease in pumping capacity is unlikely to occur. Further, as described above, NEG and the vacuum apparatus of the present embodiment can be manufactured at a low cost.

A description will be given below about the non-evaporable getter with a total storage capacity of carbon atoms, nitrogen atoms and oxygen atoms of 20 mol% or less that can obtain a desirable effect of the present application.

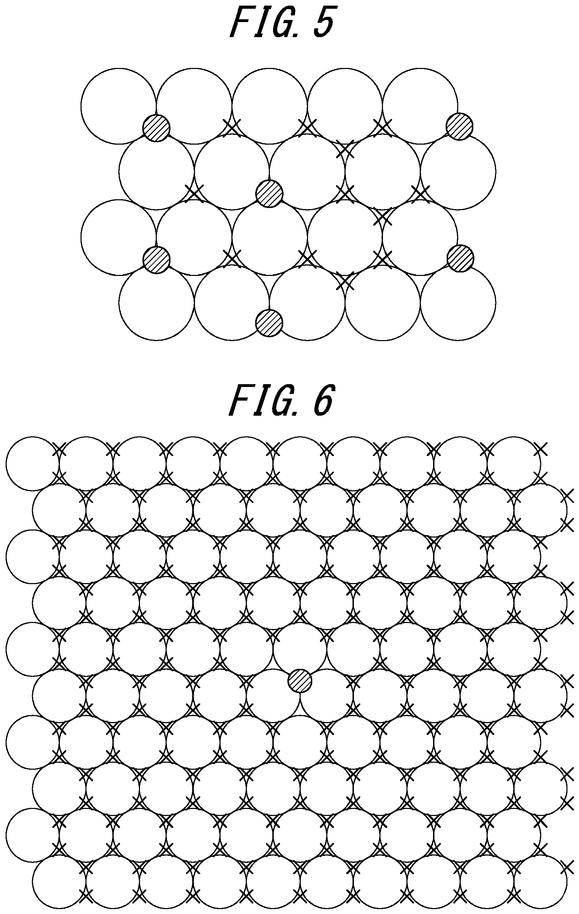

FIG. 5 illustrates a non-evaporable getter material layer and a noble metal layer when a total storage capacity of carbon atoms, nitrogen atoms and oxygen atoms is 20 mol% or less. The large white circles represent non-evaporable getter metal atoms or noble metal atoms. The small hatched circles represent carbon atoms, nitrogen atoms or oxygen atoms. The gaps between non-evaporable getter metal atoms or noble metal atoms less affected by carbon atoms, nitrogen atoms and oxygen atoms are represented by "x" marks. Hydrogen atoms are diffused to the non-evaporable getter layer or the noble metal layer through the gaps, and when the total storage capacity of carbon atoms, nitrogen atoms and oxygen atoms is 20 mol% or less, there are at least four gaps per four non-evaporable getter metal atoms or noble metal atoms, and as a result a non-evaporable getter material having a high hydrogen storage capacity can be realized.

Further, a description will be given below about a non-evaporable getter with a total storage capacity of carbon atoms, nitrogen atoms and oxygen atoms of 1 mol% or less can particularly increase a desirable effect of the present application.

FIG. 6 illustrates a non-evaporable getter material layer and a noble metal layer when the total storage capacity of carbon atoms, nitrogen atoms and oxygen atoms is 1 mol% or less. The large white circles represent non-evaporable getter metal atoms or noble metal atoms. The small hatched circle represents carbon atom, nitrogen atom or oxygen atom. The gaps between non-evaporable getter metal atoms or noble metal atoms less affected by carbon atoms, nitrogen atoms and oxygen atoms are represented by "x" marks. Hydrogen atoms are diffused to the non-evaporable getter layer or the noble metal layer through the gaps, and when the total storage capacity of carbon atoms, nitrogen atoms and oxygen atoms is 1 mol% or less, there are quite a lot of gaps through which hydrogen atoms can pass, and thus a non-evaporable getter material having a significantly high hydrogen storage capacity can be realized.

It is to be noted that, even in the non-evaporable getter with a total storage capacity of carbon atoms, nitrogen atoms and oxygen atoms of 25 mol% or less, there are at least two gaps per three non-evaporable getter metal atoms or noble metal atoms, and thus it is possible that the desirable effect of the present applicatioin can be obtained.

An example of a NEG coating apparatus of the present embodiment will be illustrated below.

In an example of the present embodiment, a NEG coating apparatus includes a pumping system composed of a turbo molecular pump or an oil-sealed rotary pump and provided with a vacuum pump, a vacuum chamber having an inner surface coated with NEG, a vacuum gauge, and a metal vapor deposition source of NEG material such as Ti and noble metal such as Pd. On the outer periphery of the vacuum valve is provided with a heater that can homogeneously heat the vacuum valve at about 150 °C. On the outer periphery of an inlet portion of the turbo molecular pump is provided with a heater that can homogeneously heat the inlet portion of the turbo molecular pump at about 80 °C. Further, on the outer periphery of the vacuum chamber to which NEG coating is applied is provided with a heater that can homogeneously heat the vacuum chamber at about 200 °C. As a heater, a sheathed heater may be homogeneously provided on the outer periphery of the vacuum chamber.

The NEG coated chamber according to the present embodiment can be manufactured by applying NEG coating by using the NEG coating apparatus according to the above described present embodiment.

The NEG coating apparatus according to the present embodiment can homogeneously apply coating of a layer of NEG material such as Ti and coating of a layer of noble metal such as Pd to the wide area on the inner surface of the vacuum chamber in a short time. With this non-evaporable getter coating, hydrogen dissociation and hydrogen storage are likely to occur on a layer of NEG material such as Ti, and a decrease in hydrogen dissociability and hydrogen penetrability of the layer of noble metal such as Pd can be suppressed. Further, the NEG coating apparatus according to the present embodiment can apply NEG coating at a low cost.

### EXAMPLES

Although the present disclosure will be described in greater detail below by using Examples, the present disclosure is not limited thereto.

### (Example 1)

A vacuum apparatus configured as illustrated in FIG. 2 was assembled in accordance with the following procedure.

A chamber was prepared in which a cylindrical inner surface made of SS304L having an outer diameter of 165 mm, an inner diameter of 158.4 mm and a length of 426 mm was electropolished. A pumping system including a butterfly valve of ultra-high vacuum spec. made by VAT Group AG, a magnetic levitation turbo molecular pump having a pumping speed of 300 L/sec. made by Edwards Co., a turbo molecular pump having a pumping speed of 50 L/sec., a foreline trap, an isolation valve, an oil-sealed rotary pump and the like was attached to a lower conflat flange having an outer diameter of 152 mm, and a vacuum gauge was attached to a side conflat flange having an outer diameter of 70 mm through an L-shaped tube. As a Ti evaporation source, a tie-back pump made by CANON ANELVA CO. was attached to each conflat flange having an outer diameter of 70 mm on both sides. Since the vacuum gauge cannot be seen from the Ti evaporation sources, Ti is not vapor deposited onto the vacuum gauge and the interior wall of vacuum piping around the vacuum gauge. Further, a sheath heater is homogeneously disposed on the outer periphery of the chamber.

The vacuum apparatus was vacuum pumped and baked. When the pressure of the vacuum chamber reached 5 × 10⁻⁸ Pa, the tie-back pump was operated and Ti was vapor deposited onto the inner surface of the vacuum chamber for six hours at an average Ti vapor deposition rate of 0.05 nm/sec. The pressure of the vacuum chamber during Ti vapor deposition was 7 × 10⁻⁶ Pa. Ti layer was formed almost all over the inner surface of the chamber, and the average thickness of the Ti layer was about 1.1 µm.

The ratio of oxygen, carbon and nitrogen (O, C, N) to Ti in the Ti layer ((X + Y + Z) when the components of the Ti layer are represented by a chemical formula of TiCₓO_{Y}N_{Z})) can be estimated from (incidence rate of residual gas including C, O and N in the vacuum chamber during Ti vapor deposition × adsorption probability) / (average Ti vapor deposition rate). The ratio of C, O and N contained in the Ti layer was indicated to be about 9 mol% on the basis of the following: the residual gas pressure of 1 × 10⁻⁴ Pa almost corresponds to the incidence rate of the residual gas of 0.3 nm/sec.; more than 80% of the residual gas is presumed to be hydrogen (H₂); and the adsorption probability is about one with respect to the Ti surface. In the case of a vacuum vapor deposition method, it is easy to obtain a pressure of the residual gas of 1 × 10⁻⁷ Pa or less in the vacuum chamber during Ti vapor deposition, and thus it is easy to obtain a ratio of C, O and N contained in the Ti layer of 1 mol% or less.

### (Example 2)

In Example 1, after the Ti vapor deposition, the vacuum apparatus was once vented to atmospheric pressure with dry nitrogen. One of the Ti evaporation sources was exchanged with a filament type Pd evaporation source (see FIG. 2B) and Pd coating was applied onto the Ti layer.

The vacuum apparatus having an inner surface of the vacuum chamber on which the Ti layer was formed was vacuum pumped and baked. When the pressure of the vacuum chamber reached 7 × 10⁻⁸ Pa, the Pd evaporation source was operated and Pd was vapor deposited onto the Ti layer on the inner surface of the vacuum chamber at an average Pd vapor deposition rate of 0.01 nm/sec. for 1,000 sec. The pressure of the vacuum chamber during Pd vapor deposition was 2 × 10⁻⁴ Pa. The Pd layer was formed almost all over the Ti layer on the inner surface of the chamber, and the average Pd layer thickness was about 10 nm.

The ratio of oxygen, carbon and nitrogen (O, C, N) to Pd in the Pd layer ((X + Y + Z) when the components of the Pd layer are represented by a chemical formula of PdCₓO_{Y}N_{Z})) can be estimated from (incidence rate of residual gas including C, O and N in a vacuum chamber during Pd vapor deposition × adsorption probability) / (average Pd vapor deposition rate). The ratio of C, O and N contained in the Pd layer was indicated to be about 12 mol% or less on the basis of the following: the pressure in the vacuum chamber during Pd vapor deposition is 2 × 10⁻⁴ Pa; the pressure of residual gas of 1 × 10⁻⁴ Pa almost corresponds to the adsorpotion rate of residual gas of 0.3 nm/sec.; more than 80% of the residual gas is presumed to be hydrogen (H₂); and the adsorption probability is estimated to be about 0.001 or less with respect to the Pd surface. In the case of a vacuum vapor deposition method, it is easy to obtain a pressure of 1 × 10⁻⁵ Pa or less in the vacuum chamber during Pd vapor deposition, and thus it is easy to obtain a ratio of 1 mol% or less for C, O and N contained in the Pd layer.

### (Comparative Example 1)

On the other hand, the vacuum chamber before Ti and Pd coatings were applied was referred to as Comparative Example 1.

In order to evaluate the effects of Ti and Pd coatings, vacuum pumping curve was measured for each of the inner surfaces of the vacuum chamber before Ti coating was applied (Comparative Example 1), the inner surface of the vacuum chamber after Ti coating was applied (Example 1) and the inner surface of the vacuum chamber further applied with Pd coating after Ti coating was applied (Example 2) for comparison.

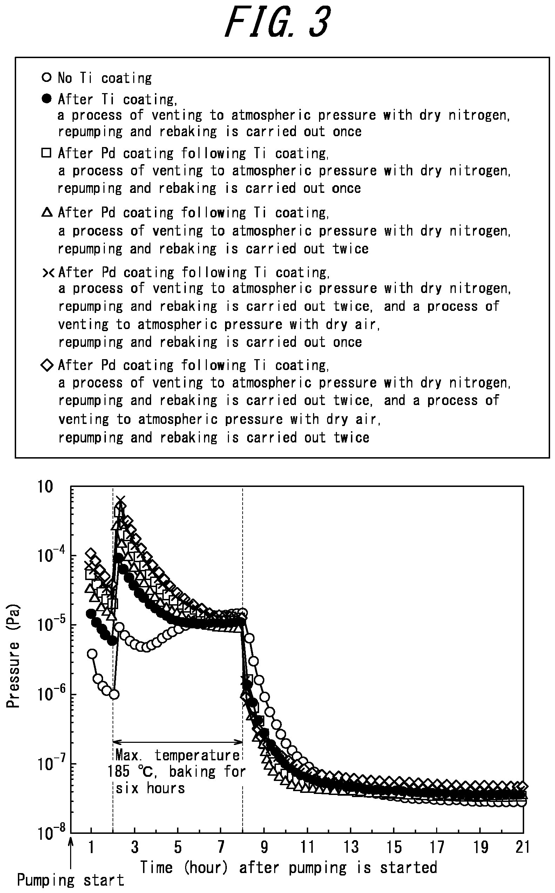

FIG. 3 illustrates pumping curves for the vacuum chambers of Examples 1 and 2 and Comparative Example 1, in which the vertical axis represents the pressure (Pa) in the vacuum chamber and the horizontal axis represents the time (hour) from starting of vacuum pumping.

The time at which pumping was started was taken as time 0. At time 0, inside the chamber was atmospheric pressure filled with dry nitrogen. The vacuum chamber was heated to a maximum temperature of 185 °C (this process is referred to as "baking") from 2 to 8 hours after the pumping was started. The temperatures were 20 °C before baking, 130 °C after 1 hour from starting of the baking, 157 °C, 173 °C, 180 °C, 183 °C and 185 °C after 2 hours, 3 hours, 4 hours, 5 hours and 6 hours (baking finished) respectively, and 92 °C, 62 °C, 47 °C, 38 °C and 32 °C in 1 hour, 2 hours, 3 hours, 4 hours and 5 hours respectively after the baking was finished. Up to 5 hours after starting the pumping, the pressures of Example 1 where Ti coating was applied and Example 2 where Ti and Pd coatings were applied are higher than the pressure of Comparative Example 1 where Ti coating was not applied. This result could have been obtained because Ti coating and Ti and Pd coatings release stored gas in the atmospheric pressure. In Example 1 where Ti coating was applied and Example 2 where Pd coating was applied onto Ti, a relatively low pressure of about 1 × 10⁻⁵ Pa, which is lower than the pressure of Comparative Example 1 where Ti coating was not applied right after baking, was obtained. The time required for pumping down to 1 × 10⁻⁷ Pa was about 10 hours for Example 1 where Ti coating was applied and about 9 and a half hours for Example 2 where Ti and Pd coatings were applied, whereas it was about 11 hours for Comparative Example 1 where Ti coating was not applied. As a result, the time required for pumping from the atmospheric pressure to 1 × 10⁻⁷ Pa was reduced by about 1 hour for Example 1 and by 1 and a half hours for Example 2 (see FIG. 3). This result shows that Ti coating and Ti and Pd coatings pump residual gas after baking (NEG performance is demonstrated).

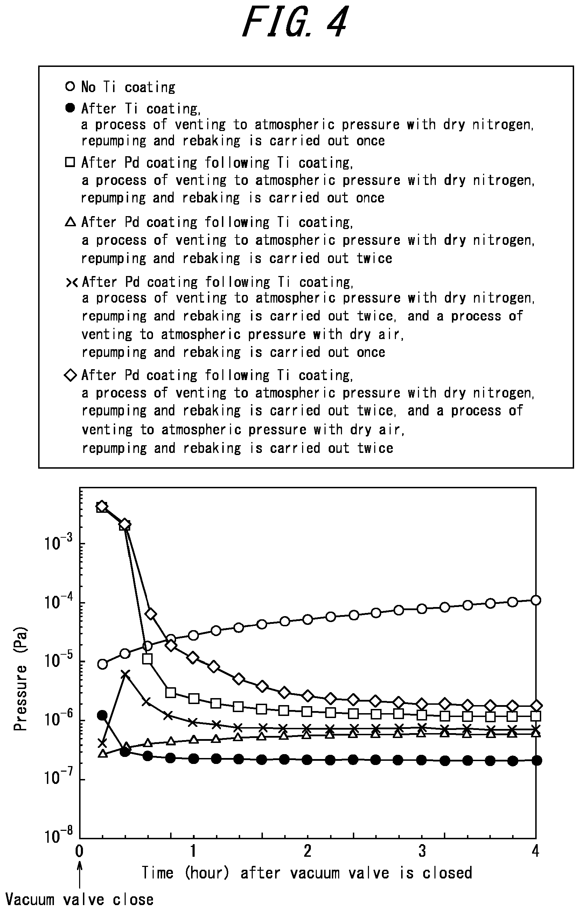

FIG. 4 illustrates a change in pressure over time when a vacuum valve connected to a pumping system is closed at the time when the pressure drops to about 4 × 10⁻⁸ Pa in the vacuum chambers of Examples 1 and 2 and Comparative Example 1. In FIG. 4, the vertical axis represents the pressure (Pa) in the vacuum chamber and the horizontal axis represents the time (hour) after closing the vacuum valve.

The time at which the valve was closed was taken as time 0. In Example 1, right after the vacuum valve was closed, the pressure rose to about 1 × 10⁻⁶ Pa due to degassing from the vacuum valve. However, the pressure immediately dropped and dropped to about 2 × 10⁻⁷ Pa in 5 hours.

Further, in Example 2, when the vacuum apparatus was used after a process of venting to the atmospheric pressure with dry nitrogen, repumping and rebaking, right after the vacuum valve was closed, the pressure rose to about 4 × 10⁻³ Pa due to degassing from the vacuum valve. However, the pressure dropped immediately and dropped to about 4 × 10⁻⁶ Pa in one hour and to about 1 × 10⁻⁶ Pa in 5 hours. It is to be noted that, right after the pumping was started, it is considered that degassing occurred from the butterfly valve due to phenomenon of peeling of NEG coating from the butterfly valve when the butterfly valve was closed.

Compared with Examples 1 and 2, in Comparative Example 1, pressure gradually rose, and rose to about 1 × 10⁻⁴ Pa in 4 and a half hours after the valve was closed.

This result indicates that Ti layer that was vacuum vapor deposited on the inner surface of the chamber is activated and the Ti layer and Pd layer that were vacuum vapor deposited on the Ti layer are activated, by baking at a maximum temperature of 185 °C for 6 hours and pump the residual gas (NEG performance is demonstrated). On the other hand, SS304L vacuum chamber applied with no Ti coating indicates no NEG action, and it is considered that since there was no vacuum pump in the vacuum chamber after the vacuum valve was closed, an increase in pressure was caused due to degassing from the inner wall of the vacuum chamber.

Furthermore, in Example 2, a change in pressure over time when the vacuum valve was closed was measured also for the case where, after the above described use, the vacuum apparatus was used after a process of atmospheric pressure vent, repumping and rebaking was carried out more than once (see FIG. 4).

In Example 2, when the vacuum apparatus was used after a process of venting to atmospheric pressure with dry nitrogen, repumping and rebaking was repeated twice, the pressure dropped to about 6 × 10⁻⁷ Pa in 5 hours after the vacuum valve was closed. Further, in Example 2, when the vacuum apparatus was used after a process of venting to atmospheric pressure with dry nitrogen, repumping and rebaking was repeated twice and further a process of venting to atmospheric pressure with dry nitrogen, repumping and rebaking was performed, the pressure dropped to about 7 × 10⁻⁷ Pa in 5 hours after the vacuum valve was closed. Moreover, in Example 2, when the vacuum apparatus was used after a process of venting to atmospheric pressure with dry nitrogen, repumping and rebaking was repeated twice and further a process of venting to atmospheric pressure with dry nitrogen, repumping and rebaking was repeated twice, the pressure dropped to about 2 × 10⁻⁶ Pa in 5 hours after the vacuum valve was closed (see FIG. 4). The above described results show that, in the NEG coated chamber in which Pd layer is formed on Ti layer, NEG performance is not decreased that much even after a process of atmospheric pressure vent, repumping and rebaking was repeated four times.

Even in the case where a process of atmospheric pressure vent, repumping and rebaking is repeated four times for Example 2, up until 7 hours after pumping is started, Example 2 where Ti and Pd coatings were carried out indicates a pressure higher than that in the case of Comparative Example 1 where Ti coating was not carried out (see FIG. 3). It is considered that this result was obtained because Ti and Pd layers release stored gas in the atmospheric pressure. This result also shows that NEG performance is not decreased that much even after a process of atmospheric pressure vent, repumping and rebaking is repeated four times.

As a result of comparison among Examples 1 and 2 and Comparative Example 1, it was found that the NEG coated chamber according to the present disclosure has the following features: (1) since NEG is activated by baking at a maximum temperature of 185 °C for 6 hours and residual gas is pumped, the time required for reaching the vacuum of 1 × 10⁻⁷ Pa or less is decreased; (2) even if the chamber and the pumping system are partitioned by the vacuum valve, the pressure inside the vacuum chamber is decreased because the NEG coated chamber has vacuum pumping action; and (3) in the NEG coated chamber in which Pd layer is formed on Ti layer, NEG performance is not decreased that much even if a process of atmospheric pressure vent, repumping and rebaking is repeated four times. Further, in the NEG coating apparatus according to the present disclosure, NEG coating can be applied to the inner surface of the vacuum chamber at a low cost. When a vacuum chamber having an inner surface applied with NEG coating according to the present disclosure is adopted to a vacuum apparatus for particle acceleration, a vacuum apparatus for manufacturing semiconductors and dispalys, and a vacuum apparatus for analysis such as an electron microscope and a photoemission spectrometer and the like, time and cost required for particle acceleration, manufacture and analysis can be reduced, and a vacuum pump for maintaining vacuum is not needed any more. As a result, a manufacturing cost can be significantly saved.

Although the present disclosure is described in greater detail below by using Example where the total storage capacity of carbon atoms, nitrogen atoms and oxygen atoms is 1 mol% or less, the present disclosure is not limited thereto.

### (Example 3)

The vacuum apparatus configured as illustrated in FIG. 7 was assembled in accordance with the following procedures.

A chamber was prepared in which a SS304L inner surface having an outer diameter of 165 mm, an inner diameter of 158.4 mm and a length of 426 mm was electropolished. A pumping system including a gate valve of ultra-high vacuum spec. made by VAT Group AG, a magnetic levitation turbo molecular pump having a pumping speed of 300 L/sec. made by Edwards Co., a turbo molecular pump having a pumping speed of 50 L/sec., a foreline trap, an isolation valve, an oil-sealed rotary pump and the like was attached to a lower conflat flange having an outer diameter of 152 mm, and a vacuum gauge was attached to a side conflat flange having an outer diameter of 70 mm through an L-shaped tube. A short tube, a four-way tube, a formed bellows having an outer diameter of 41.0 mm, an inner diameter of 30.2 mm and a length of 80 mm and a titanium/palladium evaporation source were connected in this order to a conflat flange having an outer diameter of 70 mm of a vacuum chamber. A heater was homogeneously disposed on the outer periphery of the vacuum chamber, the short tube, the four-way tube, the formed bellows and the titanium/palladium evaporation source.

The vacuum apparatus was vacuum pumped and baked, and when the pressure in the vacuum chamber reached 1.7 × 10⁻⁷ Pa, the titanium evaporation source was operated to vapor deposit the inner surface of the vacuum chamber with Ti at an average Ti vapor deposition rate of 0.05 nm/sec. for 6 hours. The pressure in the vacuum chamber during Ti vapor deposition was 2.4 × 10⁻⁷ Pa. The Ti layer was formed almost all over the entire inner surface of the formed bellows, and the average thickness of the Ti layer was about 1 µm.

The ratio of oxygen, carbon and nitrogen (O, C, N) to Ti in Ti layer ((X + Y + Z) when the components of the Ti layer are represented by a chemical formula of TiCₓO_{Y}N_{Z})) can be estimated from (incidence rate of residual gas including C, O and N in a vacuum chamber during Ti vapor deposition × adsorption probability)/(average Ti vapor deposition rate). The ratio of C, O and N contained in Ti layer was estimated to be about 1 mol% or less on the basis of the following: the pressure of residual gas of 1 × 10⁻⁴ Pa almost corresponds to the incidence rate of the residual gas of 0.3 nm/sec.; 80% or more of the residual gas is estimated to be hydrogen (H₂); and the adsorption probability is about one with respect to the Ti surface.

Subsequently the Pd evaporation source was operated and Pd vapor deposition was carried out on Ti layer on the inner surface of the vacuum chamber at an average Pd vapor deposition rate of 0.007 nm/sec. for 1,430 seconds. The pressure in the vacuum chamber during Pd vapor deposition was 1.3 × 10⁻⁷ Pa. The Pd layer was formed almost all over the Ti layer on the inner surface of the chamber, and the average Pd layer thickness was about 10 nm.

The ratio of oxygen, carbon and nitrogen (O, C, N) to Pd in Pd layer ((X + Y + Z) when the components of the Pd layer are represented by a chemical formula of PdCₓO_{Y}N_{Z})) can be estimated from (incidence rate of residual gas including C, O and N in a vacuum chamber during Pd vapor deposition × adsorption probability)/(average Pd vapor deposition rate). The ratio of C, O and N contained in Pd layer was estimated to be about 1 mol% or less on the basis of the following: the pressure in the vacuum chamber during Pd vapor deposition is 1.3 × 10⁻⁷ Pa; the pressure of the residual gas of 1 × 10⁻⁴ Pa almost corresponds to the adsorption rate of the residual gas of 0.3 nm/sec.; 80% or more of the residual gas is estimated to be hydrogen (H₂); and the adsorption probability is about 0.001 or less with respect to the Pd surface.

### (Comparative Example 2)

On the other hand, a formed bellows before coated with Ti and Pd was taken as Comparative Example 2.

FIG. 8 is a schematic cross-sectional view illustrating a part of an apparatus configured to measure a change in pressure over time of the formed bellows of Example 3 and of Comparative Example 2.

The vacuum apparatus configured as illustrated in FIG. 8 was assembled in accordance with the following procedures to evaluate the effects of Ti and Pd coatings.

A vacuum chamber was prepared in which a SS304L inner surface was electropolished. A pumping system including a gate valve of ultra-high vacuum spec. made by VAT Group AG, a magnetic levitation turbo molecular pump having a pumping speed of 450 L/sec. made by Edwards Co., a turbo molecular pump having a pumping speed of 50 L/sec., a foreline trap, an isolation valve, an oil-sealed rotary pump and the like was attached to an upper conflat flange having an outer diameter of 203 mm. An all-metal gate valve of ultra-high vacuum spec., a formed bellows, a 0.2% beryllium copper alloy short tube and a vacuum gauge were connected in this order to a conflat flange having an outer diameter of 70 mm on the side of the vacuum chamber.

A heater was homogeneously disposed on the outer periphery of the vacuum chamber, the all-metal valve, the formed bellows and the vacuum gauge. With respect to the formed bellows, the one having an inner surface before coated with Ti and Pd (Comparative Example 2) and the one having an inner surface after coated with Ti and Pd (Example 3) were used.

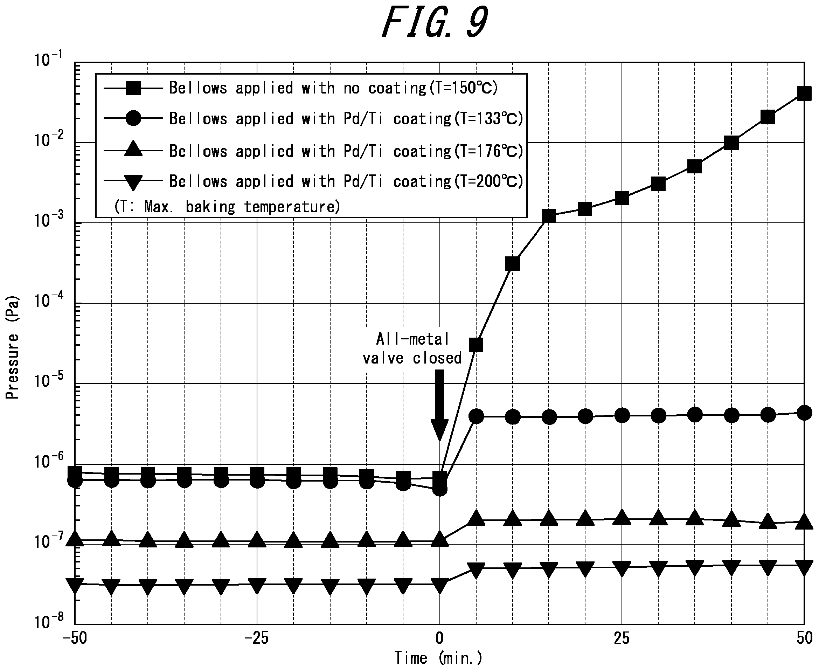

FIG. 9 illustrates a change in pressure over time when the all-metal valve connected to the pumping system was closed at the time when the pressure dropped to about 10⁻⁷ Pa to 10⁻⁸ Pa after the formed bellows of Example 3 and of Comparative Example 2 were vacuum pumped and baked. In FIG. 9, the vertical axis represents a pressure (Pa) in the vacuum chamber and the horizontal axis represents the time (min.) after the vacuum valve is closed.

The time at which the valve was closed was taken as 0 min. In Example 3, when heated at 133 °C for 12 hours, the pressure was kept at 4.6 × 10⁻⁶ Pa for 16 hours after the vacuum valve was closed. Further, when further heated at 176 °C for 3 and a half hours while the vacuum was kept, the pressure was kept at 1.7 × 10⁻⁷ Pa for 13 hours after the vacuum valve was closed. Moreover, when further heated at 200 °C for 3 and a half hours while the vacuum was kept, the pressure was kept at 6.1 × 10⁻⁸ Pa for 17 hours after the vacuum valve was closed.

Compared with Example 3, in the case of Comparative Example 2, the pressure gradually rose, and rose to about 5 × 10⁻² Pa in 50 min. after the valve was closed.

This result shows that Ti layer that was vacuum vapor deposited on the inner surface of the chamber and Pd layer that was vacuum vapor deposited on the Ti layer are activated, by baking at a maximum temperature of 133 °C for 12 hours and pump residual gas (NEG performance is demonstrated). On the other hand, the SS304L formed bellows coated with no Ti and Pd demonstrates no NEG action, and since there is no vacuum pump in the vacuum chamber after the all-metal valve is closed, it is considered that the pressure has risen due to degassing from the interior wall of the formed bellows.

As a result of comparison between Example 3 and Comparative Example 2, it was found that, in the NEG coated chamber according to the present disclosure, when the total storage capacity of carbon atoms, nitrogen atoms and oxygen atoms is 1 mol% or less, NEG is activated at least by baking at a maximum temperature of 133 °C for 12 hours, and residual gas is pumped. Since the heating temperature required for activation is low such as 133 °C, it has an advantage of being able to be adopted by a vacuum apparatus whose allowable heating temperature is low.

### INDUSTRIAL APPLICABILITY

According to the present disclosure, a NEG and a vacuum apparatus that are less likely to cause a decrease in pumping capacity (NEG performance) even if a process of atmospheric pressure vent, repumping and rebaking is repeated can be manufactured at a low cost.

The NEG and vacuum apparatus according to the present disclosure can be suitably used for a vacuum apparatus for particle acceleration, a vacuum apparatus for manufacturing semiconductors and dispalys, a vacuum apparatus for surface analysis and the like.

## Claims

1. A non-evaporable getter coated component comprising a non-evaporable getter material layer with a total storage capacity of carbon atoms, nitrogen atoms and oxygen atoms of 9 mol% or less and/or a noble metal layer with a total storage capacity of carbon atoms, nitrogen atoms and oxygen atoms of 12 mol% or less, wherein a performance of pumping residual gas is demonstrated by heating at an activation temperature of 185 °C or less under low pressure.

2. A non-evaporable getter coated chamber comprising an inner surface of a vacuum chamber coated with a non-evaporable getter material layer with a total storage capacity of carbon atoms, nitrogen atoms and oxygen atoms of 9 mol% or less and/or a noble metal layer with a total storage capacity of carbon atoms, nitrogen atoms and oxygen atoms of 12 mol% or less, wherein a performance of pumping residual gas is demonstrated by heating at an activation temperature of 185 °C or less under low pressure.

3. The non-evaporable getter coated component according to claim 1 comprising a non-evaporable getter material layer with a total storage capacity of carbon atoms, nitrogen atoms and oxygen atoms of 1 mol% or less and/or a noble metal layer with a total storage capacity of carbon atoms, nitrogen atoms and oxygen atoms of 1 mol% or less, wherein a performance of pumping residual gas is demonstrated by heating at an activation temperature of 133 °C or less under low pressure.

4. The non-evaporable getter coated chamber according to claim 2 comprising an inner surface of a vacuum chamber coated with a non-evaporable getter material layer with a total storage capacity of carbon atoms, nitrogen atoms and oxygen atoms of 1 mol% or less and/or a noble metal layer with a total storage capacity of carbon atoms, nitrogen atoms and oxygen atoms of 1 mol% or less, wherein a performance of pumping residual gas is demonstrated by heating at an activation temperature of 133 °C or less under low pressure.

5. A manufacturing method of the non-evaporable getter coated component according to claim 1 or 3, the method comprising a step of forming a non-evaporable getter material layer and/or a noble metal layer by coating a substrate with a non-evaporable getter material and/or a noble metal by a vapor deposition method under low pressure.

6. A manufacturing method of the non-evaporable getter coated chamber according to claim 2 or 4, the method comprising a step of forming a non-evaporable getter material layer and/or a noble metal layer by coating an inner surface of a vacuum chamber with a non-evaporable getter material and/or a noble metal by a vapor deposition method under low pressure.

7. A manufacturing apparatus of the non-evaporable getter coated component according to claim 1 or 3, the apparatus comprising a substrate, a non-evaporable getter material filament and/or a noble metal filament and a current feedthrough.

8. A manufacturing apparatus of the non-evaporable getter coated chamber according to claim 2 or 4, the apparatus comprising a vacuum chamber, a non-evaporable getter material filament and/or a noble metal filament and a current feedthrough.

9. A method of improving a performance of pumping residual gas of the non-evaporable getter coated component according to claim 1 or 3 by using catalytic action of the noble metal layer of the non-evaporable getter coated component according to claim 1 or 3, wherein at least carbon, nitrogen and oxygen contaminants on a surface are removed by heating under introduction of oxygen.

10. A method of improving a performance of pumping residual gas of the non-evaporable getter coated chamber according to claim 2 or 4 by using catalytic action of the noble metal layer of the non-evaporable getter coated chamber according to claim 2 or 4, wherein at least carbon, nitrogen and oxygen contaminants on a surface are removed by heating under introduction of oxygen.

11. An apparatus of improving a performance of pumping residual gas of the non-evaporable getter coated component according to claim 1 or 3 by using catalytic action of the noble metal layer of the non-evaporable getter coated component according to claim 1 or 3, wherein at least carbon, nitrogen and oxygen contaminants on a surface are removed by heating under introduction of oxygen.

12. An apparatus of improving a performance of pumping residual gas of the non-evaporable getter coated chamber according to claim 2 or 4 by using catalytic action of the noble metal layer of the non-evaporable getter coated chamber according to claim 2 or 4, wherein at least carbon, nitrogen and oxygen contaminants on a surface are removed by heating under introduction of oxygen.

## Patentansprüche

1. Mit nicht verdampfbarem Getter beschichtete Komponente, umfassend eine nicht verdampfbare Getter-Materialschicht mit einer Gesamtspeicherkapazität von Kohlenstoffatomen, Stickstoffatomen und Sauerstoffatomen von 9 Mol-% oder weniger und/oder eine Edelmetallschicht mit einer Gesamtspeicherkapazität von Kohlenstoffatomen, Stickstoffatomen und Sauerstoffatomen von 12 Mol-% oder weniger, wobei eine Leistung des Pumpens von Restgas durch Erhitzen auf eine Aktivierungstemperatur von 185 °C oder weniger unter niedrigem Druck gezeigt wird.

2. Mit nicht verdampfbarem Getter beschichtete Kammer, umfassend eine Innenfläche einer Vakuumkammer, die mit einer nicht verdampfbaren Getter-Materialschicht mit einer Gesamtspeicherkapazität von Kohlenstoffatomen, Stickstoffatomen und Sauerstoffatomen von 9 Mol-% oder weniger und/oder einer Edelmetallschicht mit einer Gesamtspeicherkapazität von Kohlenstoffatomen, Stickstoffatomen und Sauerstoffatomen von 12 Mol-% oder weniger beschichtet ist, wobei eine Leistung beim Pumpen von Restgas durch Erhitzen auf eine Aktivierungstemperatur von 185 °C oder weniger unter niedrigem Druck gezeigt wird.

3. Mit nicht verdampfbarem Getter beschichtete Komponente nach Anspruch 1, umfassend eine nicht verdampfbare Getter-Materialschicht mit einer Gesamtspeicherkapazität von Kohlenstoffatomen, Stickstoffatomen und Sauerstoffatomen von 1 Mol-% oder weniger und/oder eine Edelmetallschicht mit einer Gesamtspeicherkapazität von Kohlenstoffatomen, Stickstoffatomen und Sauerstoffatomen von 1 Mol-% oder weniger, wobei eine Leistung des Pumpens von Restgas durch Erhitzen auf eine Aktivierungstemperatur von 133 °C oder weniger unter niedrigem Druck gezeigt wird.

4. Mit nicht verdampfbarem Getter beschichtete Kammer nach Anspruch 2, umfassend eine Innenfläche einer Vakuumkammer, die mit einer nicht verdampfbaren Getter-Materialschicht beschichtet ist, mit einer Gesamtspeicherkapazität von Kohlenstoffatomen, Stickstoffatomen und Sauerstoffatomen von 1 Mol-% oder weniger und/oder einer Edelmetallschicht mit einer Gesamtspeicherkapazität von Kohlenstoffatomen, Stickstoffatomen und Sauerstoffatomen von 1 Mol-% oder weniger, wobei eine Leistung des Pumpens von Restgas durch Erhitzen auf eine Aktivierungstemperatur von 133 °C oder weniger unter niedrigem Druck gezeigt wird.

5. Herstellungsverfahren der mit nicht verdampfbarem Getter beschichteten Komponente nach Anspruch 1 oder 3, wobei das Verfahren einen Schritt des Bildens einer nicht verdampfbaren Getter-Materialschicht und/oder einer Edelmetallschicht durch Beschichten eines Substrats mit einem nicht verdampfbaren Getter-Material und/oder einem Edelmetall durch ein Aufdampfverfahren unter niedrigem Druck umfasst.

6. Herstellungsverfahren der mit nicht verdampfbarem Getter beschichteten Kammer nach Anspruch 2 oder 4, wobei das Verfahren einen Schritt des Bildens einer nicht verdampfbaren Getter-Materialschicht und/oder einer Edelmetallschicht durch Beschichten einer Innenfläche einer Vakuumkammer mit einem nicht verdampfbaren Getter-Material und/oder einem Edelmetall durch ein Aufdampfverfahren unter niedrigem Druck umfasst.

7. Herstellungsvorrichtung der mit nicht verdampfbarem Getter beschichteten Komponente nach Anspruch 1 oder 3, wobei die Vorrichtung ein Substrat, ein nicht verdampfbares Getter-Materialfilament und/oder ein Edelmetallfilament und eine Stromdurchführung umfasst.

8. Herstellungsvorrichtung der mit nicht verdampfbarem Getter beschichteten Kammer nach Anspruch 2 oder 4, wobei die Vorrichtung eine Vakuumkammer, ein nicht verdampfbares Getter-Materialfilament und/oder ein Edelmetallfilament und eine Stromdurchführung umfasst.

9. Verfahren zum Verbessern einer Leistung des Pumpens von Restgas der mit nicht verdampfbarem Getter beschichteten Komponente nach Anspruch 1 oder 3 unter Verwendung der katalytischen Wirkung der Edelmetallschicht der mit nicht verdampfbarem Getter beschichteten Komponente nach Anspruch 1 oder 3, wobei mindestens Kohlenstoff-, Stickstoff- und Sauerstoffverunreinigungen auf einer Oberfläche durch Erhitzen unter Einbringen von Sauerstoff entfernt werden.

10. Verfahren zum Verbessern einer Leistung des Pumpens von Restgas der mit nicht verdampfbarem Getter beschichteten Kammer nach Anspruch 2 oder 4 unter Verwendung der katalytischen Wirkung der Edelmetallschicht der mit nicht verdampfbarem Getter beschichteten Kammer nach Anspruch 2 oder 4, wobei mindestens Kohlenstoff-, Stickstoff- und Sauerstoffverunreinigungen auf einer Oberfläche durch Erhitzen unter Einbringen von Sauerstoff entfernt werden.

11. Vorrichtung zum Verbessern einer Leistung des Pumpens von Restgas der mit nicht verdampfbarem Getter beschichteten Komponente nach Anspruch 1 oder 3 unter Verwendung der katalytischen Wirkung der Edelmetallschicht der mit nicht verdampfbarem Getter beschichteten Komponente nach Anspruch 1 oder 3, wobei mindestens Kohlenstoff-, Stickstoff- und Sauerstoffverunreinigungen auf einer Oberfläche durch Erhitzen unter Einbringen von Sauerstoff entfernt werden.

12. Vorrichtung zum Verbessern einer Leistung des Pumpens von Restgas der mit nicht verdampfbarem Getter beschichteten Kammer nach Anspruch 2 oder 4 unter Verwendung der katalytischen Wirkung der Edelmetallschicht der mit nicht verdampfbarem Getter beschichteten Kammer nach Anspruch 2 oder 4, wobei mindestens Kohlenstoff-, Stickstoff- und Sauerstoffverunreinigungen auf einer Oberfläche durch Erhitzen unter Einbringen von Sauerstoff entfernt werden.

## Revendications

1. Composant enrobé de getter non évaporable comprenant une couche de matériau getter non évaporable ayant une capacité totale de stockage d'atomes de carbone, d'atomes d'azote et d'atomes d'oxygène inférieure ou égale à 9 % en moles et/ou une couche de métal noble ayant une capacité totale de stockage d'atomes de carbone, d'atomes d'azote et d'atomes d'oxygène inférieure ou égale à 12 % en moles, les performances de pompage de gaz résiduel étant démontrées par chauffage à une température d'activation inférieure ou égale à 185 °C sous basse pression.

2. Chambre enrobée de getter non évaporable comprenant une surface intérieure d'une chambre à vide enrobée d'une couche de matériau getter non évaporable ayant une capacité totale de stockage d'atomes de carbone, d'atomes d'azote et d'atomes d'oxygène inférieure ou égale à 9 % en moles et/ou d'une couche de métal noble ayant une capacité totale de stockage d'atomes de carbone, d'atomes d'azote et d'atomes d'oxygène inférieure ou égale à 12 % en moles, les performances de pompage de gaz résiduel étant démontrées par chauffage à une température d'activation inférieure ou égale à 185 °C sous basse pression.

3. Composant enrobé de getter non évaporable selon la revendication 1, comprenant une couche de matériau getter non évaporable ayant une capacité totale de stockage d' atomes de carbone, d'atomes d'azote et d'atomes d'oxygène inférieure ou égale à 1 % en moles et/ou une couche de métal noble ayant une capacité totale de stockage d'atomes de carbone, d'atomes d'azote et d'atomes d'oxygène inférieure ou égale à 1 % en moles, les performances de pompage de gaz résiduel étant démontrées par chauffage à une température d'activation inférieure ou égale à 133 °C sous basse pression.

4. Chambre enrobée de getter non évaporable selon la revendication 2, comprenant une surface intérieure d'une chambre à vide enrobée d'une couche de matériau getter non évaporable ayant une capacité totale de stockage d'atomes de carbone, d'atomes d'azote et d'atomes d'oxygène inférieure ou égale à 1 % en moles et/ou une couche de métal noble ayant une capacité totale de stockage d'atomes de carbone, d'atomes d'azote et d'atomes d'oxygène inférieure ou égale à 1 % en moles, les performances de pompage de gaz résiduel étant démontrées par chauffage à une température d'activation inférieure ou égale à 133 °C sous basse pression.

5. Méthode de fabrication du composant enrobé de getter non évaporable selon la revendication 1 ou 3, la méthode comprenant une étape de formation d'une couche de matériau getter non évaporable et/ou d'une couche de métal noble par enduction d'un substrat avec un matériau getter non évaporable et/ou un métal noble selon un procédé de dépôt en phase vapeur sous basse pression.

6. Méthode de fabrication de la chambre enrobée de getter non évaporable selon la revendication 2 ou 4, la méthode comprenant une étape de formation d'une couche de matériau getter non évaporable et/ou d'une couche de métal noble par enduction d'une surface intérieure d'une chambre à vide avec un matériau getter non évaporable et/ou un métal noble selon un procédé de dépôt en phase vapeur sous basse pression.

7. Appareil de fabrication du composant enrobé de getter non évaporable selon la revendication 1 ou 3, l'appareil comprenant un substrat, un filament de matériau getter non évaporable et/ou un filament de métal noble et une traversée de courant.

8. Appareil de fabrication de la chambre enrobée de getter non évaporable selon la revendication 2 ou 4, l'appareil comprenant une chambre à vide, un filament de matériau getter non évaporable et/ou un filament de métal noble et une traversée de courant.

9. Méthode d'amélioration des performances de pompage de gaz résiduel du composant enrobé de getter non évaporable selon la revendication 1 ou 3 par utilisation de l'action catalytique de la couche de métal noble du composant enrobé de getter non évaporable selon la revendication 1 ou 3, au moins les contaminants de type carbone, azote et oxygène sur une surface étant éliminés par chauffage sous introduction d'oxygène.

10. Méthode d'amélioration des performances de pompage de gaz résiduel de la chambre enrobée de getter non évaporable selon la revendication 2 ou 4 par utilisation de l'action catalytique de la couche de métal noble de la chambre enrobée de getter non évaporable selon la revendication 2 ou 4, au moins les contaminants de type carbone, azote et oxygène sur une surface étant éliminés par chauffage sous introduction d'oxygène.

11. Appareil d'amélioration des performances de pompage de gaz résiduel du composant enrobé de getter non évaporable selon la revendication 1 ou 3 par utilisation de l'action catalytique de la couche de métal noble du composant enrobé de getter non évaporable selon la revendication 1 ou 3, au moins les contaminants de type carbone, azote et oxygène sur une surface étant éliminés par chauffage sous introduction d'oxygène.

12. Appareil d'amélioration des performances de pompage de gaz résiduel de la chambre enrobée de getter non évaporable selon la revendication 2 ou 4 par utilisation de l'action catalytique de la couche de métal noble de la chambre enrobée de getter non évaporable selon la revendication 2 ou 4, au moins les contaminants de type carbone, azote et oxygène sur une surface étant éliminés par chauffage sous introduction d'oxygène.
